# EUROPÄISCHE PATENTSCHRIFT

(11) **EP 2 653 018 B1**
(45) Veröffentlichungstag und Bekanntmachung des Hinweises auf die Patenterteilung: **07.01.2015**
(21) Anmeldenummer: 11778881.0
(22) Anmeldetag: 03.11.2011
(51) Int. Cl.: H05K 7/14, B60R 16/023

(54) **STEUERGERÄT UND VERFAHREN ZUM HERSTELLEN EINES STEUERGERÄTS**
CONTROL DEVICE AND METHOD FOR PRODUCING A CONTROL DEVICE
APPAREIL DE COMMANDE ET PROCÉDÉ DE FABRICATION D'UN APPAREIL DE COMMANDE

(30) Priorität: 15.12.2010 DE 102010063158
(43) Veröffentlichungstag der Anmeldung: 23.10.2013
(73) Patentinhaber: Robert Bosch GmbH, 70442 Stuttgart (DE)
(72) Erfinder: KROECKEL, Markus, 71701 Schwieberdingen (DE)
(86) Internationale Anmeldenummer: PCT/EP2011/069341
(87) Internationale Veröffentlichungsnummer: WO 2012/079838

(56) Entgegenhaltungen:
- EP-A1- 0 014 391
- EP-A1- 0 200 597
- DE-A1- 3 531 958
- GB-A- 1 471 309

## Beschreibung

### Stand der Technik

Die Erfindung betrifft ein Steuergerät nach dem Oberbegriff des Anspruchs 1. Ferner betrifft die Erfindung ein Verfahren zum Herstellen eines erfindungsgemäßen Steuergeräts.

Ein Steuergerät nach dem Oberbegriff des Anspruchs 1 ist bereits allgemein bekannt. Dabei wird eine Leiterplatte in ein sogenanntes "Einschubgehäuse" eingeschoben, bis diese in ihrer Einschubrichtung in einer Endposition innerhalb des Gehäuses angekommen ist. Das Einschieben wird hierbei ggf. durch leistenartige Führungen für die Leiterplatte erleichtert, so dass Beschädigungen beim Einführen bzw. Einschieben der Leiterplatte in das Gehäuse vermieden werden können. In der Endposition innerhalb des Gehäuses wird die Leiterplatte beispielsweise über eine mit der Leiterplatte verbundene, stirnseitig am Gehäuse angeordnete Steckerleiste innerhalb des Gehäuses fixiert. Kritisch bei derartigen Gehäusekonstruktionen ist die Vibrationsbelastung der Leiterplatte beim Betrieb des Steuergeräts innerhalb eines Kraftfahrzeugs. Insbesondere ist es erforderlich, dass die Leiterplatte nicht zu Vibrationen bzw. Schwingungen angeregt wird, die beispielsweise die Lötverbindungen der elektronischen Bauteile beeinflussen bzw. schädigen können.

Weiterhin ist aus dem Stand der Technik ein Gehäuse für ein Steuergerät bekannt, das einen haubenartigen Deckel aufweist. Hierbei wird der Deckel unter randseitiger Zwischenlage der Leiterplatte mit der Grundplatte verbunden. Zur Vermeidung der angesprochenen Vibrationsbelastungen der Leiterplatte weist diese dabei ein elastisches Dämpfungselement auf, das zwischen der Leiterplatte und der zugewandten Seite des haubenförmigen Deckelteils angeordnet ist, wobei das Dämpfungselement mit einer gewissen Axialkraft auf die Leiterplatte drückt und somit Schwingungen der Leiterplatte absorbiert bzw. dämpft.

Aus der DE 35 31 958 A1 ist eine Vorrichtung bekannt, die zum vibrationsfreien Abstützen eines Verbunds aus mehreren Leiterplatten in einem Gehäuse vorgesehen ist. Die Vorrichtung weist einen elastischen Ausgleichsring auf, der auf einer der Innenwand des Gehäuses zugewandten Seite einer Leiterplatte angeordnet ist und der von einem beweglichen Druckstück gegen die Leiterplatte gedrückt wird. Das Druckstück wird dabei mittels eines Rastbolzens in einer Durchgangsöffnung einer Leiterplatte befestigt. Beim Einschieben der Anordnung aus Leiterplatte und Druckstück in das Gehäuse, wird das Druckstück gegen den Ausgleichsring gedrückt. bis das Druckstück an einer Innenwand des Gehäuses anliegt. Dadurch wird eine vibrations- und spannungsarme Halterung der Leiterplatte erzielt.

### Offenbarung der Erfindung

Ausgehend von dem dargestellten Stand der Technik liegt der Erfindung die Aufgabe zugrunde, ein Steuergerät nach dem Oberbegriff des Anspruchs 1 derart weiterzubilden, dass auch bei der Verwendung von sogenannten Einschubgehäusen Vibrationsbelastungen der Leiterplatte während des Betriebs des Steuergeräts in einem Kraftfahrzeug vermieden werden. Diese Aufgabe wird bei einem Steuergerät mit den Merkmalen des Anspruchs 1 gelöst. Der Erfindung liegt dabei die Idee zugrunde, wenigstens ein Dämpfungselement vorzusehen, das an der Leiterplatte befestigt ist, wobei das Gehäuse des Steuergeräts einen Deformationsabschnitt aufweist, der durch Eindellen mit dem Dämpfungselement in Wirkverbindung gelangt. Mit anderen Worten gesagt bedeutet dies, dass es trotz des Dämpfungselements möglich ist, die Leiterplatte in ein Einschubgehäuse einzuschieben, ohne dass das Dämpfungselement dabei mit Bauteilen innerhalb des Steuergeräts bzw. des Gehäuses in Kontakt gerät. Erst in der Endposition der Leiterplatte innerhalb des Gehäuses wird die erforderliche Verbindung zwischen dem Dämpfungselement, der Leiterplatte und dem Gehäuse des Steuergeräts durch Eindellen des Deformationsabschnitts ausgebildet.

Vorteilhafte Weiterbildungen des erfindungsgemäßen Steuergeräts sind in den Unteransprüchen angegeben.

Besonders bevorzugt ist eine Ausgestaltung der Erfindung, bei der auf jeweils beiden Seiten der Leiterplatte ein Dämpfungselement angeordnet ist. Dadurch lassen sich insbesondere Biegespannungen auf die Leiterplatte durch die axiale Kraft infolge der Dämpfungselemente vermeiden.

Auch ist es möglich, ein Steuergerät zu realisieren, in dessen Gehäuse zwei Leiterplatten angeordnet sind, wobei beide Leiterplatten vibrationsgedämmt im Gehäuse angeordnet sind. Hierbei ist es vorgesehen, dass zwischen den Leiterplatten ein Dämpfungselement angeordnet ist und dass das Dämpfungselement vorzugsweise zu den anderen Dämpfungselementen fluchtend angeordnet ist.

Das Einführen der Leiterplatte bzw. der Leiterplatten in das Gehäuse wird erleichtert, wenn das Gehäuse Führungselemente für die wenigstens eine Leiterplatte aufweist, die in Einschubrichtung der wenigstens einen Leiterplatte ausgerichtet sind.

In einer weiteren Ausgestaltung der Erfindung ist es vorgesehen, dass das Gehäuse im Bereich des Deformationsbereichs ein separates, mit dem Gehäuse verbundenes Zusatzelement aufweist, das in Richtung der Leiterplatte ragt, und im montierten Zustand der wenigstens einen Leiterplatte nach dem Eindellen mit dem Dämpfungselement zusammenwirkt. Dadurch können relativ niedrig bzw. kurz bauende Dämpfungselemente eingesetzt werden, wobei zwischen der Leiterplatte und der zugewandten Seite des Gehäuses ein relativ großer Abstand ausgebildet sein kann. Trotzdem ist nur eine relativ geringe Eindellung an dem Deformationsbereich erforderlich, da der axiale Abstand zwischen der Leiterplatte bzw. dem Dämpfungselement und dem Gehäuse durch das Zusatzelement überbrückt werden kann. Weiterhin lassen sich durch die Länge bzw. die Eigenschaften des Zusatzelements die Dämpfungseigenschaften in gewünschter Art und Weise relativ einfach beeinflussen.

Um das Eindellen bzw. Ausbilden des Deformationsabschnitts während der Fertigung bzw. der Montage der Leiterplatte im Gehäuse zu vereinfachen, ist es darüber hinaus in einer vorteilhaften Ausgestaltung der Erfindung vorgesehen, dass das Gehäuse im Bereich des Deformationsbereichs ein vorgedelltes, insbesondere durch Tiefziehen hergestelltes Gehäuse aufweist, wobei der Deformationsbereichs in Richtung der Leiterplatte ragt und im montierten Zustand der wenigstens einen Leiterplatte nach dem Eindellen mit dem Dämpfungselement zusammenwirkt.

Die Erfindung umfasst auch ein Verfahren zum Herstellen eines erfindungsgemäßen Steuergeräts. Hierbei ist es vorgesehen, dass in der Endposition der wenigstens einen Leiterplatte in dem Gehäuse wenigstens ein Deformationsbereich des Gehäuses in einer Richtung senkrecht zur wenigstens einen Leiterplatte von der Gehäuseaußenseite eingedellt und in klemmender Wirkverbindung zu wenigstens einem, in Ausrichtung mit dem Deformationsbereich angeordneten Dämpfungselement gebracht wird. Ein derartiges Verfahren ermöglicht eine problemlose Montage bzw. ein problemloses Einführen der wenigstens einen Leiterplatte in das Gehäuse.

Weitere Vorteile, Merkmale und Einzelheiten der Erfindung ergeben sich aus der nachfolgenden Beschreibung bevorzugter Ausführungsbeispiele sowie anhand der Zeichnung.

Diese zeigt in:
- Fig. 1 bis 3: jeweils vereinfachte Längsschnitte durch ein erfindungsgemäßes Steuergerät mit einer Leiterplatte während verschiedener Montagephasen,
- Fig. 4 und 5: einen Querschnitt, bzw. einen Längsschnitt durch ein Steuergerät, in dessen Gehäuse zwei Leiterplatten angeordnet sind, bevor die Leiterplatten im Gehäuse über Dämpfungselemente fixiert sind,
- Fig. 6 und 7: einen Querschnitt bzw. einen Längsschnitt durch das Steuergerät gemäß Fig. 4 und 5 nach dem Fixieren der beiden Leiterplatten und
- Fig. 8 bis 10: ein gegenüber den Fig. 4 und 5 modifiziertes Gehäuse zur Verwendung mit zwei Leiterplatten bei der Montage der Leiterplatten während verschiedener Zeitpunkte, jeweils im Längsschnitt.

Gleiche Bauteile, bzw. Bauteile mit gleicher Funktion sind in den Figuren mit den gleichen Bezugsziffern versehen.

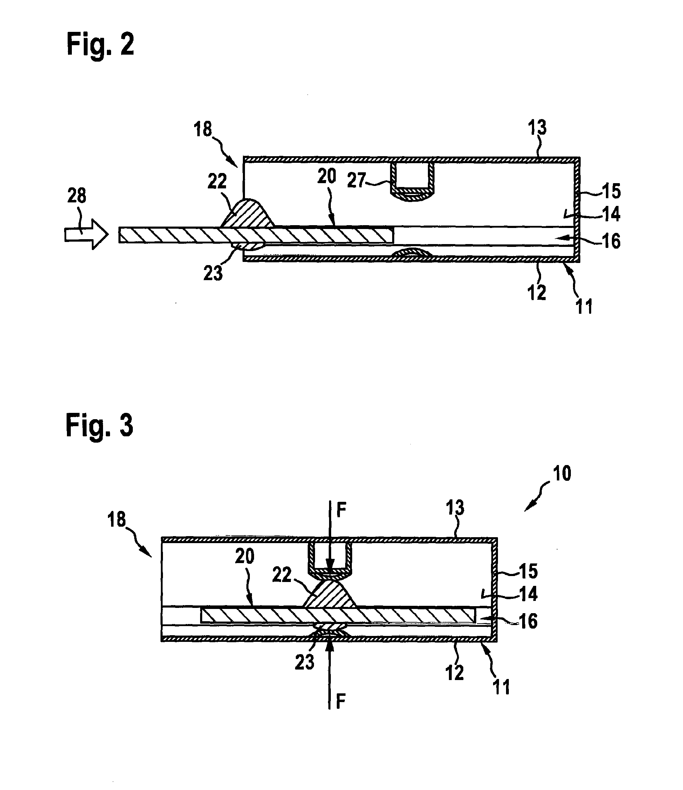

In der Fig. 3 ist ein erstes erfindungsgemäßes Steuergerät 10 dargestellt, wie es insbesondere als Steuergerät 10 in einem Kraftfahrzeug verwendet wird. Hierbei ist das Steuergerät 10 vorzugsweise mit der Karosserie des Kraftfahrzeugs, gegebenenfalls über zusätzliche Trägerelemente bzw. Halteelemente, fest verbunden.

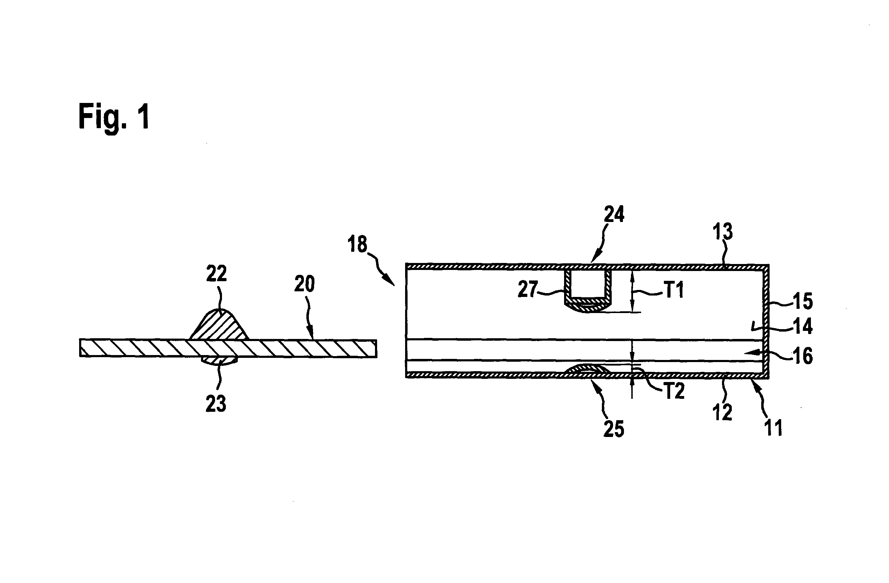

Das Steuergerät 10 weist ein sogenanntes "Einschubgehäuse" auf, dessen Gehäuse 11 zumindest im Wesentlichen topfförmig ausgebildet ist. Das bedeutet, dass das Gehäuse 11 eine untere Wand 12, eine obere Wand 13, zwei Seitenwände 14, von denen lediglich eine Seitenwand 14 in den Fig. 1 bis 3 erkennbar ist, sowie einen Boden 15 aufweist. Die Wände 12, 13, die Seitenwände 14 sowie der Boden 15 können dabei jeweils als separate Bauteile ausgebildet sein, oder vorzugsweise zumindest teilweise, beispielsweise durch Tiefziehen, als einstückiges Bauteil ausgebildet sein. Insbesondere bestehen die untere Wand 12 und die obere Wand 13 des Gehäuses 11 aus Blech bzw. plastisch verformbarem Material. Ferner sind an der Gehäuseinnenseite an den beiden Seitenwänden 14 jeweils Führungselemente 16, z.B. in Form von Sicken oder separaten Bauteilen angeordnet, die vorzugsweise über die gesamte Länge der beiden Seitenwände 14, d.h. von der Öffnung 18 des Gehäuses 11 bis zum Boden 15 reichen.

Innerhalb des Gehäuses 11 ist ein Schaltungsträger in Form einer Leiterplatte 20 angeordnet. Die Leiterplatte 20 trägt auf ihrer Oberseite bzw. ihrer Unterseite nicht dargestellte elektrische oder elektronische Bauteile. Erfindungswesentlich ist, dass mit der Leiterplatte 20 im Ausführungsbeispiel zwei Dämpfungselemente 22, 23 verbunden sind. Hierbei weist das auf der Oberseite der Leiterplatte 20 angeordnete obere Dämpfungselement 22 eine größere Höhe auf als das an der Unterseite der Leiterplatte 20 angeordnete untere Dämpfungselement 23. Im dargestellten Ausführungsbeispiel ist das obere Dämpfungselement 22 im Querschnitt kegelförmig mit einer gerundeten Spitze ausgebildet, während das untere Dämpfungselement 23 im Wesentlichen zylindrisch ausgebildet ist.

Die beiden Dämpfungselemente 22, 23 sind auf nicht näher dargestellte Art und Weise mit der Leiterplatte 20 fest verbunden, z.B. durch eine Klebung oder durch ein mechanisches, in den Figuren nicht erkennbares Bauteil. Weiterhin bestehen die Dämpfungselemente 22, 23 aus einem elastischen Material, beispielsweise einem Gummi, der in einer Richtung insbesondere senkrecht zur Ebene der Leiterplatte 20 elastisch deformierbar ist.

Das Gehäuse 11 weist an seiner oberen Wand 13 einen ersten Deformationsbereich 24, und an der unteren Wand 12 einen zweiten Deformationsbereich 25 auf. Hierbei kann es vorgesehen sein, dass die beiden Deformationsbereiche 24, 25 bereits beim Herstellungsprozess des Gehäuses 11, insbesondere wenn die beiden Wände 12, 13 des Gehäuses 11 durch einen Tiefziehprozess ausgebildet sind, in Form von Eindellungen (vor-) ausgebildet wurden. Ferner erkennt man anhand der Figuren, dass der erste Deformationsbereich 24 eine Tiefe T1 aufweist. Demgegenüber weist der zweite Deformationsbereich 25 eine Tiefe T2 auf, wobei T2 kleiner ist als T1. Die beiden Deformationsbereiche 24, 25 sind ferner in einer Ebene senkrecht zu den Wänden 12, 13 fluchtend zueinander angeordnet und beispielsweise zumindest auf an dem der Leiterplatte 20 zugewandten Endbereich kugelabschnittsförmig geformt.

Ergänzend wird erwähnt, dass der erste Deformationsbereich 24 auch beispielsweise durch ein an der Gehäuseinnenseite angeordnetes Zusatzelement 27 gebildet sein kann, das in Wirkverbindung mit der oberen Wand 13 des Gehäuses 11 angeordnet ist.

Der Montageprozess des Steuergeräts 10 erfolgt entsprechend der Abfolge der Fig. 1 bis 3 derart, dass die Leiterplatte 20 mit den vormontierten Dämpfungselementen 22, 23 in Richtung des Pfeils 28 in das Gehäuse 11 eingeschoben wird. Hierbei verhindern die Führungselemente 16 insbesondere, dass auf der Leiterplatte 20 angeordnete Bauteile beim Einschieben der Leiterplatte 20 in das Gehäuse 11 mechanisch vorgeschädigt oder geschädigt werden. In der in der Fig. 3 dargestellten Endposition der Leiterplatte 20 in dem Gehäuse 11 sind die beiden Dämpfungselemente 22, 23 mit den beiden Deformationsbereichen 24, 25 ausgerichtet bzw. fluchten mit diesen, wobei jedoch zunächst noch ein Abstand (nicht dargestellt) zwischen den Dämpfungselementen 22, 23 und den Deformationsbereichen 24, 25 besteht.

Zum Fixieren der Leiterplatte 20 in dem Gehäuse 11 wird dann von der Gehäuseaußenseite auf die beiden Deformationsbereiche 24, 25 eine senkrecht zur Leiterplatte 20 gerichtete Prägekraft F ausgeübt, die die Deformationsbereiche 24, 25 weiter in Richtung der beiden Dämpfungselemente 22, 23 eindrücken, bis diese in Wirkverbindung mit den Dämpfungselementen 22, 23 gelangen und diese mit einer bestimmten Kontaktkraft beaufschlagen.

In der in der Fig. 3 dargestellten Endposition ist somit die Leiterplatte 20 zumindest in einer Ebene senkrecht zur Leiterplatte 20 in dem Gehäuse 11 fixiert. Die Fixierung der Leiterplatte 20 in Einschubrichtung erfolgt entweder durch separate, in den Figuren nicht dargestellte Elemente oder aber, bevorzugt, durch eine ebenfalls nicht dargestellte Steckerleiste, die mit der Leiterplatte 20 bzw. deren Anschlüssen mechanisch und elektrisch verbunden ist und gleichzeitig dem Verschluss der Öffnung 18 des Gehäuses 11 dient.

Ergänzend wird erwähnt, dass es selbstverständlich im Rahmen der Erfindung liegt, mehr als zwei Dämpfungselemente 22, 23 auf der Leiterplatte 20 vorzusehen. Weiterhin ist die Form bzw. der Querschnitt der Dämpfungselemente 22, 23 nicht auf die dargestellten kegelförmigen bzw. zylindrischen Dämpfungselemente 22, 23 beschränkt. Auch ist es beispielsweise denkbar, auf eines der beiden Dämpfungselemente 22, 23 zu verzichten, so dass die Leiterplatte 20 in einer Ebene senkrecht zu deren Erstreckung gegen einen festen Anschlag, z.B. gegen die Führungselemente 16 gedrückt wird, sobald die entsprechende Prägekraft F auf das eine Dämpfungselement 22, 23 ausgeübt wird.

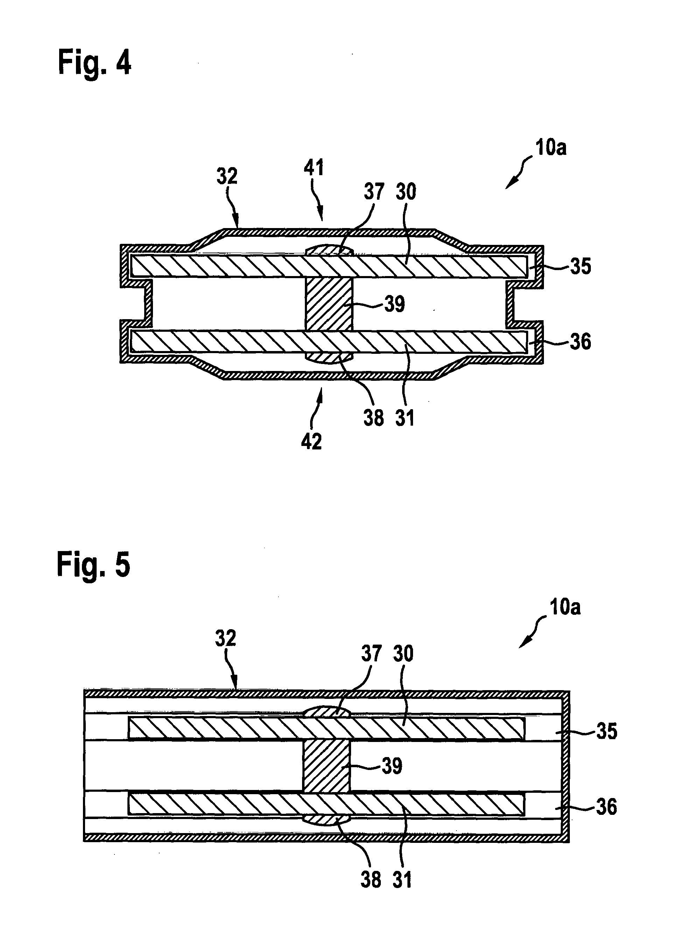

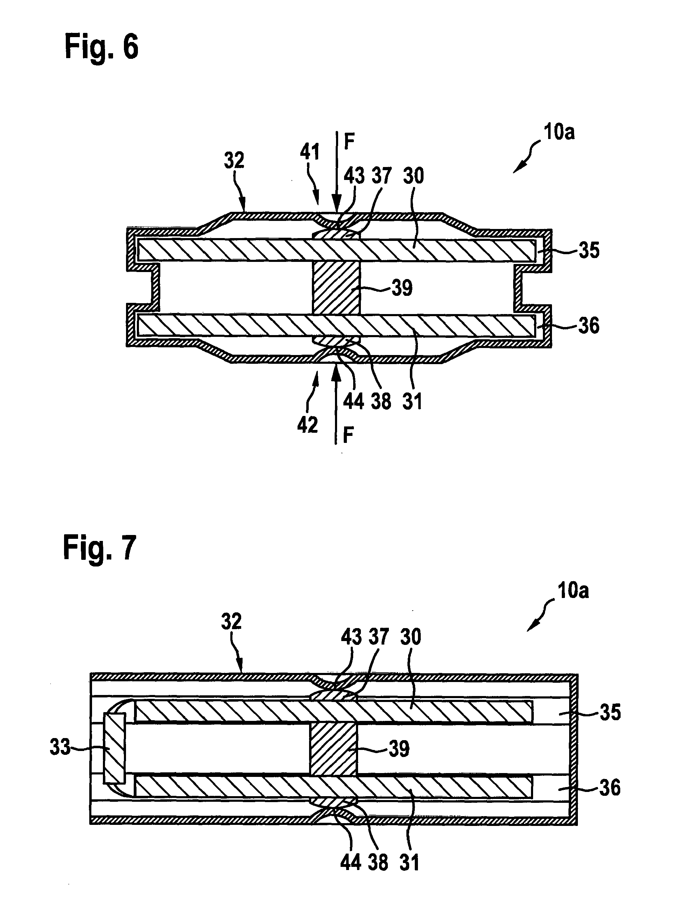

In den Fig. 4 bis 7 ist ein gegenüber dem Steuergerät 10 modifiziertes Steuergerät 10a dargestellt. Das Steuergerät 10a weist zwei Leiterplatten 30, 31 auf, die innerhalb des Gehäuses 32 parallel zueinander angeordnet sind, und die mittels eines elektrischen Verbindungselements 33, insbesondere einer Litze, elektrisch miteinander verbunden sind. Ferner erkennt man, dass das Gehäuse 32 des Steuergeräts 10a für die beiden Leiterplatten 30, 31 jeweils über die Längsrichtung des Gehäuses 32 verlaufende Führungen 35, 36 aufweist, die beispielsweise durch einen Tiefziehprozess gebildet sind. Auf der Oberseite der oberen Leiterplatte 30 ist ein erstes Dämpfungselement 37 angeordnet, und auf der Unterseite der unteren Leiterplatte 31 ein zweites Dämpfungselement 38. Vorzugsweise bzw. optional kann es vorgesehen sein, dass zwischen der Unterseite der oberen Leiterplatte 30 und der Oberseite der unteren Leiterplatte 31 ein drittes Dämpfungselement 39 angeordnet ist, welches fluchtend zu den beiden anderen Dämpfungselementen 37, 38 angeordnet ist. Dieses dritte, vorab an den Leiterplatten 30, 31 befestigte Dämpfungselement 39 sorgt gleichzeitig für den richtigen Abstand zwischen den beiden Leiterplatten 30, 31 beim Einschieben in das Gehäuse 32, so dass eine Beschädigung von Bauelementen ausgeschlossen werden kann.

Hinsichtlich der Form bzw. Anordnung der Dämpfungselemente 37 bis 39 gilt das in Bezug auf die Dämpfungselemente 22, 23 Beschriebene. Der Montageprozess des Steuergeräts 10a erfolgt derart, dass zunächst die beiden Leiterplatten 30, 31 vollständig bis in ihre Endposition in das Gehäuse 32 des Steuergeräts 10a eingeschoben werden. Anschließend, d.h. erst nachdem die beiden Leiterplatten 30, 31 ihre Endposition erreicht haben, werden im Bereich der beiden Deformationsbereiche 41, 42 die Eindellungen 43, 44 durch Aufbringen einer entsprechenden Prägekraft F ausgebildet. Die Deformationsbereiche 41, 42 sind somit vor dem Ausbilden der Eindellungen 43, 44 eben ausgebildet. Ein derartiger Montage- bzw. Fertigungsprozess, bei dem die Deformationsbereiche 41, 42 bzw. die Eindellungen 43, 44 erst nach Erreichen der Endposition der Leiterplatten 30, 31 in dem Gehäuse 32 ausgebildet werden, hat gegenüber dem Steuergerät 10, bei dem die Deformationsbereiche 24, 25 bereits teilweise vorgebildet sind den Vorteil, dass die Bauteile auf den Leiterplatten 30, 31 auch eine relativ große Höhe aufweisen können, ohne dass sie beim Einschieben der Leiterplatten 30, 31 in Konflikt mit vorgeprägten Deformationsbereichen 24, 25 gelangen können.

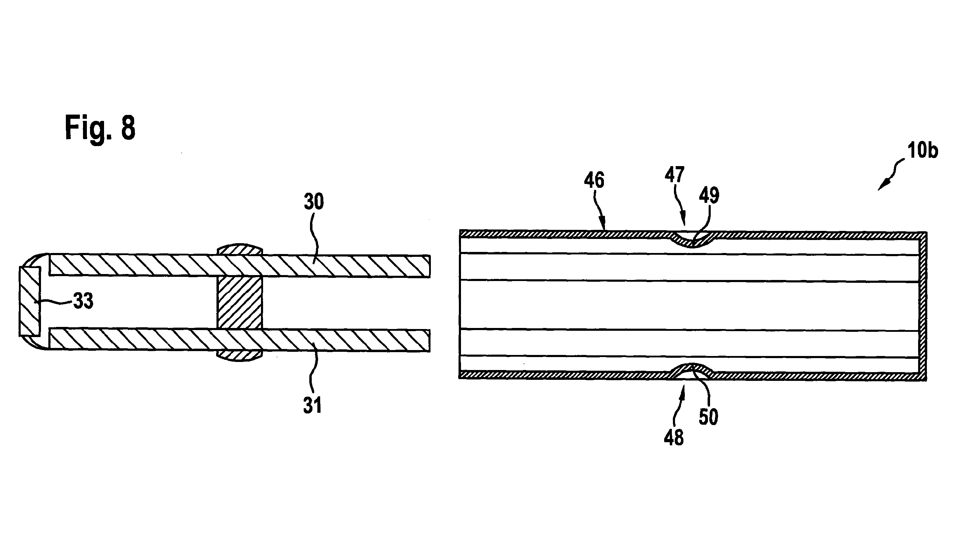

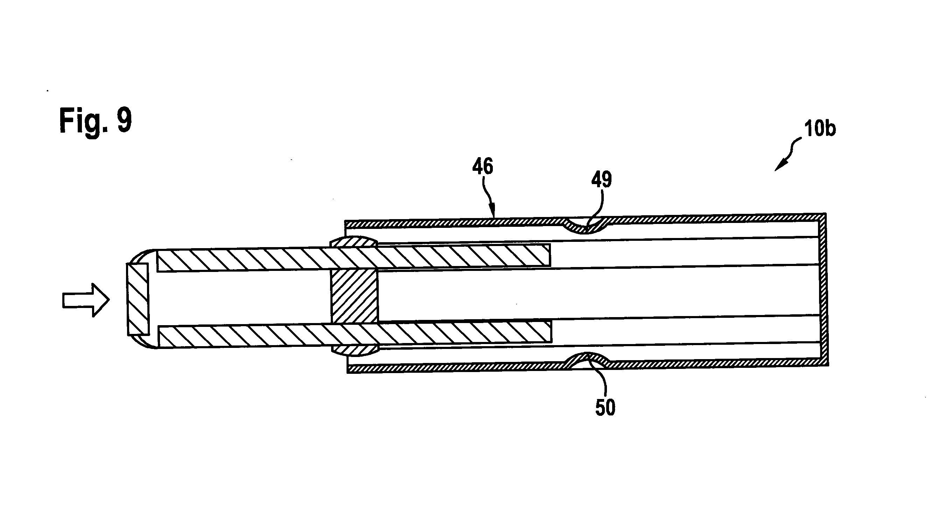

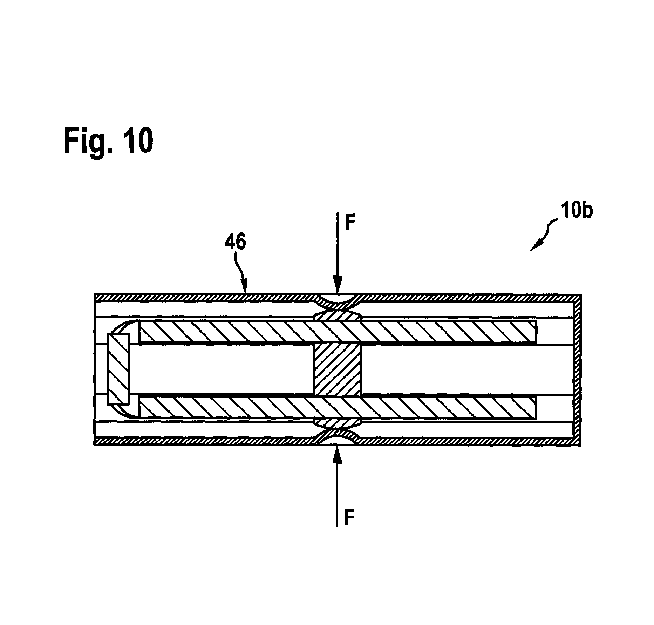

In den Fig. 8 bis 10 ist ein Steuergerät 10b dargestellt, das sich von dem Steuergerät 10a dadurch unterscheidet, dass bei dem Steuergerät 10b bzw. in dem Gehäuse 46 des Steuergeräts 10b die Deformationsbereiche 47, 48 in Form von Eindellungen 49, 50 bereits vorgebildet sind. Insofern entspricht der Montageprozess des Steuergeräts 10b dem Steuergerät 10a, lediglich werden bei dem Steuergerät 10b zwei Leiterplatten 31,31 verwendet.

Die soweit beschriebenen Steuergeräte 10, 10a, 10b können in vielfältiger Art und Weise abgewandelt bzw. modifiziert werden, ohne vom Erfindungsgedanken abzuweichen. Dieser besteht in der Verwendung von Dämpfungselementen 22, 23, 37 bis 39 in einem Einschubgehäuse, die nach der Montage der Leiterplatte 20 bzw. der Leiterplatten 30, 31 in Wirkverbindung mit Gehäuseabschnitten, insbesondere durch plastisches Verformen des Gehäuses 11, 32, 46, gelangen.

## Patentansprüche

1. Steuergerät (10; 10a; 10b), insbesondere für ein Kraftfahrzeug, mit einem als Einschubgehäuse ausgebildeten Gehäuse (11; 32; 46), in dessen Innenraum wenigstens eine Leiterplatte (20; 30, 31) angeordnet ist,
**dadurch gekennzeichnet,**
**dass** der wenigstens einen Leiterplatte (20; 30, 31) wenigstens ein, vorzugsweise mit der Leiterplatte (20; 30, 31) verbundenes, zumindest in einer Ebene senkrecht zur Leiterplatte (20; 30, 31) elastisches Dämpfungselement (22, 23; 37, 38, 39) zugeordnet ist, und dass das wenigstens eine Dämpfungselement (22, 23; 37, 38, 39) mit einem Deformationsbereich (24, 25; 41, 42; 47, 48) des Gehäuses (11; 32; 46) zusammenwirkt, der durch Eindellen eines Gehäuseabschnitts ausgebildet ist und dabei einen Anlagekontakt mit dem wenigstens einen Dämpfungselement (22, 23; 37, 38, 39) erzeugt.

2. Steuergerät nach Anspruch 1,
**dadurch gekennzeichnet,**
**dass** auf jeweils beiden Seiten der Leiterplatte (20; 30, 31) ein Dämpfungselement (22, 23; 37, 38, 39) angeordnet ist.

3. Steuergerät nach Anspruch 1,
**dadurch gekennzeichnet,**
**dass** zwei Leiterplatten (30, 31) vorgesehen sind, dass zwischen den Leiterplatten (30, 31) ein Dämpfungselement (39) angeordnet ist, und dass das Dämpfungselement (39) vorzugsweise zu den anderen Dämpfungselementen (37, 38) fluchtend angeordnet ist.

4. Steuergerät nach einem der Ansprüche 1 bis 3,
**dadurch gekennzeichnet,**
**dass** das Gehäuse (11; 32; 46) Führungselemente (16; 35, 36) für die wenigstens eine Leiterplatte (20; 30, 31) aufweist, die in Einschubrichtung der wenigstens einen Leiterplatte (20; 30, 31) ausgerichtet sind.

5. Steuergerät nach einem der Ansprüche 1 bis 4,
**dadurch gekennzeichnet,**
**dass** das Gehäuse (11) im Bereich des Deformationsbereichs (24) ein separates, mit dem Gehäuse (11) verbundenes Zusatzelement (27) aufweist, das in Richtung der Leiterplatte (20) ragt, und im montierten Zustand der Leiterplatte (20) nach dem Eindellen mit dem Dämpfungselement (22) zusammenwirkt.

6. Steuergerät nach einem der Ansprüche 1 bis 4,
**dadurch gekennzeichnet,**
**dass** das Gehäuse (11; 46) im Bereich des Deformationsbereichs (24, 25; 47, 48) ein vorgedelltes, insbesondere durch Tiefziehen hergestelltes Gehäuse (11; 46) aufweist, wobei der Deformationsbereichs (24, 25; 47, 48) in Richtung der Leiterplatte (20; 30, 31) ragt und im montierten Zustand der wenigstens einen Leiterplatte (20; 30, 31) nach dem Eindellen mit dem Dämpfungselement (22, 23; 37, 38, 39) zusammenwirkt.

7. Steuergerät nach einem der Ansprüche 1 bis 6,
**dadurch gekennzeichnet,**
**dass** das Gehäuse (11; 32; 46) als tiefgezogenes, einstückiges Bauteil aus Blech ausgebildet ist.

8. Verfahren zum Herstellen eines Steuergeräts (10; 10a; 10b) nach einem der Ansprüche 1 bis 7, wobei in das als Einschubsteuergerät ausgebildete Steuergerät (10; 10a; 10b) wenigstens eine Leiterplatte (20; 30, 31) eingeschoben wird,
**dadurch gekennzeichnet,**
**dass** in der Endposition der wenigstens einen Leiterplatte (20; 30, 31) in dem Gehäuse (11; 32; 46) wenigstens ein Deformationsbereich (24, 25; 41, 42; 47, 48) des Gehäuses (11; 32; 46) in einer Richtung senkrecht zur wenigstens einen Leiterplatte (20; 30, 31) von der Gehäuseaußenseite eingedellt und in klemmender Wirkverbindung zu wenigstens einem, in Ausrichtung mit dem Deformationsbereich (24, 25; 41, 42; 47, 48) angeordneten Dämpfungselement (22, 23; 37, 38, 39) gebracht wird.

9. Verfahren nach Anspruch 8,
**dadurch gekennzeichnet,**
**dass** beim Vorhandensein mehrerer Leiterplatten (30, 31) zwischen den Leiterplatten (30, 31) ein Dämpfungselement (39) angeordnet wird, das die Leiterplatten (30, 31) zueinander beabstandet.

10. Verfahren nach Anspruch 8 oder 9,
**dadurch gekennzeichnet,**
**dass** auf gegenüberliegenden Seiten des Gehäuses (32) Deformationsbereiche (41, 42) vorgesehen sind, die erstmals in der Endposition der wenigstens einen Leiterplatte (30, 31) in dem Gehäuse (32) eingedellt werden.

## Claims

1. Control device (10; 10a; 10b), in particular for a motor vehicle, having a housing (11; 32; 46) which is embodied as a slide-in housing and in the interior of which at least one printed circuit board (20; 30, 31) is arranged,
**characterized**
**in that** the at least one printed circuit board (20; 30, 31) is assigned at least one damping element (22, 23; 37, 38, 39) which is preferably connected to the printed circuit board (20; 30, 31) and is elastic at least in a plane perpendicular to the printed circuit board (20; 30, 31), and in that the at least one damping element (22, 23; 37, 38, 39) interacts with a deformation region (24, 25; 41, 42; 47, 48) of the housing (11; 32; 46), which is formed by denting inward a housing section, and in the process said damping element (22, 23; 37, 38, 39) produces a bearing contact with the at least one damping element (22, 23; 37, 38, 39).

2. Control device according to Claim 1, **characterized**
**in that** a damping element (22, 23; 37, 38, 39) is arranged on each of the two sides of the printed circuit board (20; 30, 31).

3. Control device according to Claim 1, **characterized**
**in that** two printed circuit boards (30, 31) are provided, in that a damping element (39) is arranged between the printed circuit boards (30, 31), and in that the damping element (39) is preferably arranged flush with the other damping elements (37, 38).

4. Control device according to one of Claims 1 to 3,
**characterized**
**in that** the housing (11; 32; 46) has guide elements (16; 35, 36) for the at least one printed circuit board (20; 30, 31) which are oriented in the slide-in direction of the at least one printed circuit board (20; 30, 31).

5. Control device according to one of Claims 1 to 4,
**characterized**
**in that** the housing (11) has, in the region of the deformation region (24), a separate additional element (27) which is connected to the housing (11), which projects in the direction of the printed circuit board (20), and in the mounted state of the printed circuit board (20) interacts with the inward damping element (22) after the denting.

6. Control device according to one of Claims 1 to 4,
**characterized**
**in that** the housing (11; 46) has, in the region of the deformation region (24, 25; 47, 48), a pre-dented housing (11; 46), manufactured, in particular, by deep drawing, wherein the deformation region (24, 25; 47, 48) projects in the direction of the printed circuit board (20; 30, 31), and in the mounted state of the at least one printed circuit board (20; 30, 31) interacts with the damping element (22, 23; 37, 38, 39) after the denting.

7. Control device according to one of Claims 1 to 6,
**characterized**
**in that** the housing (11; 32; 46) is embodied as a deep-drawn, single-piece component made of sheet metal.

8. Method for manufacturing a control device (10; 10a; 10b) according to one of Claims 1 to 7, wherein at least one printed circuit board (20; 30, 31) is slid into the control device (10; 10a; 10b) which is embodied as a slide-in control device,
**characterized**
**in that** in the end position of the at least one printed circuit board (20; 30, 31) in the housing (11; 32; 46) at least one deformation region (24, 25; 41, 42; 47, 48) of the housing (11; 32; 46) is dented inward from the outside of the housing in a direction perpendicular to the at least one printed circuit board (20; 30, 31), and is placed in a clamping operative connection with at least one damping element (22, 23; 37, 38, 39) which is arranged in alignment with the deformation region (24, 25; 41, 42; 47, 48).

9. Method according to Claim 8,
**characterized**
**in that** when a plurality of printed circuit boards (30, 31) are present, a damping element (39) is arranged between the printed circuit boards (30, 31), which damping element (39) spaces apart the printed circuit boards (30, 31) from one another.

10. Method according to Claim 8 or 9,
**characterized**
**in that** deformation regions (41, 42), which are first dented inward in the end position of the at least one printed circuit board (30, 31) in the housing (32) are provided on opposite sides of the housing (32).

## Revendications

1. Appareil de commande (10 ; 10a ; 10b), en particulier pour un véhicule automobile, comprenant un boîtier (11 ; 32 ; 46) réalisé en tant que boîtier insérable dans l'espace interne duquel est disposée au moins une carte à circuits imprimés (20 ; 30, 31),
**caractérisé en ce**
**qu'**au moins un élément d'amortissement (22, 23 ; 37, 38, 39), de préférence connecté à la carte à circuits imprimés (20 ; 30, 31), élastique au moins dans un plan perpendiculaire à la carte à circuits imprimés (20 ; 30, 31), est associé à l'au moins une carte à circuits imprimés (20 ; 30, 31), et en ce que l'au moins un élément d'amortissement (22, 23 ; 37, 38, 39) coopère avec une région de déformation (24, 25 ; 41, 42 ; 47, 48) du boîtier (11 ; 32 ; 46) qui est réalisée par bosselage d'une portion de boîtier et produit en l'occurrence un contact d'application avec l'au moins un élément d'amortissement (22, 23 ; 37, 38, 39).

2. Appareil de commande selon la revendication 1, **caractérisé en ce**
**qu'**un élément d'amortissement (22, 23 ; 37, 38, 39) est disposé à chaque fois sur les deux côtés de la carte à circuits imprimés (20 ; 30, 31).

3. Appareil de commande selon la revendication 1, **caractérisé en ce que**
deux cartes à circuits imprimés (30, 31) sont prévues, **en ce qu'**entre les cartes à circuits imprimés (30, 31) est disposé un élément d'amortissement (39) et **en ce que** l'élément d'amortissement (39) est disposé de préférence en affleurement avec les autres éléments d'amortissement (37, 38).

4. Appareil de commande selon l'une quelconque des revendications 1 à 3,
**caractérisé en ce que**
le boîtier (11 ; 32 ; 46) présente des éléments de guidage (16 ; 35, 36) pour l'au moins une carte à circuits imprimés (20 ; 30, 31), lesquels sont orientés dans la direction d'insertion de l'au moins une carte à circuits imprimés (20 ; 30, 31).

5. Appareil de commande selon l'une quelconque des revendications 1 à 4,
**caractérisé en ce que**
le boîtier (11) présente, dans la région de la région de déformation (24), un élément ajouté séparé (27), connecté au boîtier (11), qui fait saillie dans la direction de la carte à circuits imprimés (20) et qui coopère, dans l'état monté de la carte à circuits imprimés (20), après le bosselage, avec l'élément d'amortissement (22).

6. Appareil de commande selon l'une quelconque des revendications 1 à 4,
**caractérisé en ce que**
le boîtier (11 ; 46) présente, dans la région de la région de déformation (24, 25 ; 47, 48), un boîtier pré-bosselé (11 ; 46) fabriqué notamment par emboutissage profond, la région de déformation (24, 25 ; 47, 48) faisant saillie dans la direction de la carte à circuits imprimés (20 ; 30, 31) et, dans l'état monté de l'au moins une carte à circuits imprimés (20 ; 30, 31), après le bosselage, coopérant avec l'élément d'amortissement (22, 23 ; 37, 38, 39).

7. Appareil de commande selon l'une quelconque des revendications 1 à 6,
**caractérisé en ce que**
le boîtier (11 ; 32 ; 46) est réalisé sous forme de composant d'une seule pièce embouti en tôle.

8. Procédé de fabrication d'un appareil de commande (10 ; 10a ; 10b) selon l'une quelconque des revendications 1 à 7, dans lequel au moins une carte à circuits imprimés (20 ; 30, 31) est insérée dans l'appareil de commande (10 ; 10a ; 10b) réalisé sous forme d'appareil de commande insérable,
**caractérisé en ce que**
dans la position d'extrémité de l'au moins une carte à circuits imprimés (20 ; 30, 31) dans le boîtier (11 ; 32 ; 46), au moins une région de déformation (24, 25 ; 41, 42 ; 47, 48) du boîtier (11 ; 32 ; 46) est bosselée dans une direction perpendiculaire à l'au moins une carte à circuits imprimés (20 ; 30, 31) depuis le côté extérieur du boîtier et est amenée en liaison fonctionnelle par serrage avec au moins un élément d'amortissement (22, 23 ; 37, 38, 39) disposé en alignement avec la région de déformation (24, 25 ; 41, 42 ; 47, 48).

9. Procédé selon la revendication 8,
**caractérisé en ce**
**qu'**en présence de plusieurs cartes à circuits imprimés (30, 31), un élément d'amortissement (39) est disposé entre les cartes à circuits imprimés (30, 31), lequel sépare les unes des autres les cartes à circuits imprimés (30, 31).

10. Procédé selon la revendication 8 ou 9, **caractérisé en ce que**
des régions de déformation (41, 42) sont prévues sur des côtés opposés du boîtier (32), lesquelles sont bosselées pour la première fois dans la position d'extrémité de l'au moins une carte à circuits imprimés (30, 31) dans le boîtier (32).
